# EUROPEAN PATENT APPLICATION

(11) **EP 4 564 414 A1**
(43) Date of publication of application: **04.06.2025**
(21) Application number: 23213550.9
(22) Date of filing: 30.11.2023
(51) Int. Cl.: H01L 21/677

(54) **STOCKER FOR STORING A SEMICONDUCTOR FABRICATION ARTICLE**

(71) Applicant: Brooks Automation (Germany) GmbH, 78256 Steißlingen (DE)
(72) Inventor: Meier, Karl, 8240 Thayngen (CH); Hug, Andreas, 8555 Müllheim (CH)
(74) Representative: Dehns Germany Partnerschaft mbB

(57) **Abstract**

The invention provides a stocker (100) for storing a semiconductor fabrication article, particularly a reticle, with a motorized storage unit (120), particularly a rotatable storage carousel, with a plurality of storage positions and at least two handling devices (112, 114) each configured to access the at least two storage positions and to place an article therein for storage or to retrieve an article therefrom, wherein the at least two handling devices (112, 114) are arranged at mutually different positions with respect to the storage unit (120) and are configured to access storage positions within the storage unit (120) substantially independently from one another. Alternatively or additionally, the storage unit may comprise at least two storage portions (121, 122, 123, 124, 125, 126), wherein each one of the storage portions (121, 122, 123, 124, 125, 126) comprises a motor (131, 132, 133, 134, 135, 136) configured to displace the respective storage portion (121, 122, 123, 124, 125, 126) substantially independently of any of the remaining storage portions (121, 122, 123, 124, 125, 126). Further, a method for operating such a stocker (100) is provided.

## Description

The present invention relates to a stocker for semiconductor fabrication articles (for example reticles) and a method of operating said stocker.

### Background

Photolithography processes are widely used as one of the key steps in the manufacture of integrated circuits (ICs) and other semiconductor-related devices and/or structures. However, as the dimensions of features produced by such processes decrease, the importance of photolithography for the production of miniature ICs or other devices and/or structures rises.

In photolithography, a geometric pattern is transferred from a photomask (typically referred to as reticle) onto a substrate, for example a semiconductor wafer, by the use of light, a photosensitive layer and a subsequent etching step. Depending on the desired feature size on the substrate, the feature size of the reticle needs to be adapted as well as the wavelength of the light used for pattern transfer, with consideration of the Raleigh criterion.

In order to reduce the smallest achievable feature size, it has been proposed to use extreme ultraviolet (EUV) radiation. EUV radiation is electromagnetic radiation having a wavelength within the range of 5-20 nm, for example within the range of 5-10 nm.

Any contamination of the reticle may reduce the imaging performance of the photolithographic process and may in more serious cases require the reticle to be replaced. The reticle is typically expensive and therefore any reduction in the frequency with which it must be replaced is advantageous. Furthermore, replacement of the reticle is a time-consuming process, during which the photolithographic process may have to be supported, thereby reducing its efficiency, which is undesirable.

For EUV applications, particle contamination with particle sizes of less than 10 nm as well as chemical contamination, for example by adsorption of volatile organic compounds, can be relevant.

The reticles used for such EUV applications are therefore typically stored in a storage stocker, and retrieved when needed in connection with the lithography exposure equipment. Usually, the reticles are contained in a double shell container (double pod) comprising a so-called EUV outer pod (EOP) and an EUV inner pod (EIP).

Such a double pod is described in further detail in US 2019/0214287 A1, for example.

Reticles (as well as other articles, for example raw or processed semiconductor substrates or partially or completely produces ICs) may be stored within encasements or carriers, such as the mentioned double pods, (e.g. in so-called carrier stockers) or without such encasements or carriers (e.g. in so-called bare stockers or semi-bare stockers). This is independent of the specific wavelength used in the lithography process. For example, DUV-processes may also be used.

### Disclosure of the invention

The present invention relates to a stocker for semiconductor fabrication articles (for example reticles) and a method of operating said stocker as set out in the respective independent claims. The invention specifically pertains to using at least partially redundant handling devices used for accessing storage positions in the stocker to provide higher throughput and/or improved availability in case of a defect or malfunction.

In detail, a stocker for storing a semiconductor fabrication article, particularly a reticle, according to a first aspect of the present invention comprises a motorized storage unit, particularly a rotatable storage carousel, with a plurality of storage positions and at least two handling devices each configured to access the at least two storage positions and to place an article therein for storage or to retrieve an article therefrom, wherein the at least two handling devices are arranged at different positions with respect to the storage unit and are configured to access storage positions within the storage unit substantially independently from one another. By providing at least two substantially independent handling devices, the throughput (or mean amount of handling operations per time unit) can be increased significantly, as each handling device can access a storage unit while another one of the at least two handling devices is still busy with another handling operation. Furthermore, in case of a malfunction of a handling device, another one of the at least two handling devices may still be used, thereby increasing the availability of the stocker (in that case with accordingly reduced throughput).

According to a second aspect of the invention, a stocker for storing a semiconductor fabrication article, particularly a reticle, comprises a motorized storage unit, particularly a rotatable storage carousel, with a plurality of storage positions and at least one handling device configured to access the storage positions and to place an article therein for storage or to retrieve an article therefrom, the storage unit comprises at least two, three, four, five or more storage portions, wherein each one of the storage portions comprises a motor configured to displace the respective storage portion substantially independently from any of the remaining storage portions. In case of a storage carousel, the storage portions may be configured as coaxially arranged axial storage portions stacked one above the other. This independent displaceability (further) increases throughput since the at least two handling devices may access different storage positions at the same time, as long as those storage positions are associated with different storage portions. Furthermore, in case of a malfunction of a motor of one of the storage portions, the remaining storage portions remain accessible, thereby (further) increasing the availability of the stocker and/or stored articles. This second aspect, i.e. independently displaceable storage portions, can be combined with the first aspect, i.e. redundant handling devices, to synergistically enhance the advantageous effects of both aspects.

In at least one embodiment, two or more neighbouring storage portions are mechanically couplable with one another such that two or more coupled storage portions can be simultaneously displaced by means of the motor of one of the coupled storage portions, particularly in a case in which a motor of at least one of the storage portions is not functional. This further increases the availability of the stocker and the articles stored therein, because all the storage positions remain accessible with this arrangement.

In at least one embodiment, each of the at least two handling devices is associated with at least one respective load port. A load port is an interface unit connecting the stocker with peripheral equipment, such as a transport system. Typically, load ports are configured to receive an article enclosed within an encasement or carrier from outside the stocker, to purge an atmosphere within the encasement and/or surrounding the encasement and optionally to open the encasement or carrier and/or to retrieve the article from within the encasement or carrier. Furthermore, load ports are typically configured to perform those operations reversely in order to provide an article from within the stocker to the peripheral equipment outside the stocker. Each of the at least one load ports may be accessible by each of the at least two handling devices, or some or all of the at least one load ports may be exclusively associated with a single one of the at least two handling devices, such that only the handling device associated with the respective load port may access the load port. In some embodiments, each load port is associated with only a single one of the at least two handling devices, respectively. This facilitates the operation of the handling devices, as no check needs to be conducted, if a specific load port is in use by another of the at least two handling devices.

In at least one embodiment, each of the at least two storage positions is configured to hold exactly one article, particularly without any mobile or transport encasement or carrier. In some embodiments, dedicated storage encasements may be used. This separate storage of single articles improves storage conditions in terms of safety and potential for (cross) contamination of the stored articles as well as storage density (number of stored articles per volume of storage space).

Typically, reticles are stored with an encasement, for example in a double pod as described above. This conventional solution provides for quick access to reticles, since packing into transport containers is not required, when they are already stored within such transport containers, e.g. double pods. However, due to the better storage conditions and density mentioned, it may be beneficial to store even such vulnerable articles as reticles in a bare stocker, i.e. without encasement, or semi-bare stocker, i.e. several reticles together in a common box or a single reticle in a custom encasement, i.e. a special pod optimized only for storage. The stocker provided by embodiments of this invention alleviates the longer access time by providing at least two handling devices, such that even for critical articles such as reticles, such a bare or semi-bare stocker may be used.

According to the present invention, a method of operating a stocker for storing a semiconductor fabrication article with at least two handling devices comprises controlling a first one of the at least two handling devices to perform a first handling operation regarding a first article, the first handling operation requiring access to a first storage position within a motorized storage unit of the stocker and controlling a second one of the at least two handling devices to perform a second handling operation regarding a second article, the second handling operation requiring access to a second storage position within the storage unit. Particularly the second handling operation may be performed during a time in which the first handling device is performing at least a part of the first handling operation. The second storage position can be different from the first storage position. This method, similarly to the above described aspect relating to the stocker, increases throughput and availability for the same reasons as set out herein above.

In at least one embodiment, the method further comprises controlling the motorized storage unit to move the first storage position within a reach of the first handling device and the second storage position within a reach of the second handling device, respectively. This reduces the required movement of the handling device and, therefore, further increases operation speed and throughput and makes it possible to use simpler handling devices, since less freedom of movement is required for accessing the respective storage positions as compared to a stationary storage unit. This is also viable in a case in which the stocker comprises a single handling device and a storage unit with two or more motorized storage portions. In such a case, a second storage portion can already move the storage position required for a subsequent (i.e. "second") handling operation while the handling device is still busy with the current task (i.e. the "first" handling operation).

In a case, in which the storage unit comprises at least two, three, four, five or more storage portions, wherein each one of the storage portions is displaceable independently from any of the remaining storage portions by a respective motor, the method further comprises identifying the storage portions in which the first and second storage positions are located, respectively; controlling the respective motor of the identified storage portions to move the first and second storage positions within the reach of the at least one or the first and second handling devices, respectively; determining if the displacement of the identified storage portions was effected as controlled, and, in case at least one storage portion was not displaced as controlled, coupling the respective storage portion with a neighbouring storage portion and controlling the motor of the neighbouring storage portion to move the first and second storage position within the reach of the first or second handling device, respectively. This, as already described above in relation to the respective embodiment of the stocker, improves the availability of stored articles and the stocker as such.

### Brief description of the appended drawings

Figure 1 schematically depicts an embodiment of a stocker according to the present invention.
Figure 2 schematically illustrates an embodiment of a method of operating a stocker according to the present invention.

### Detailed description

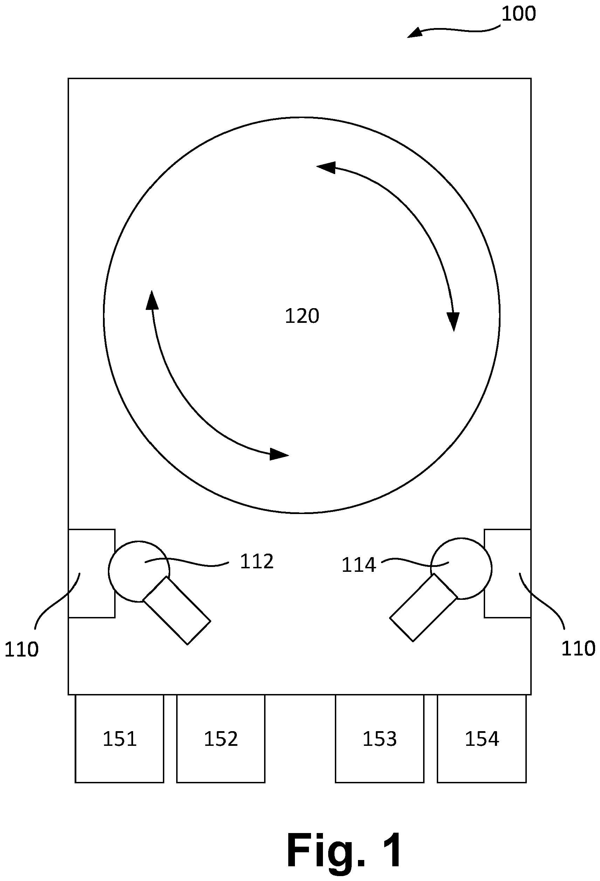

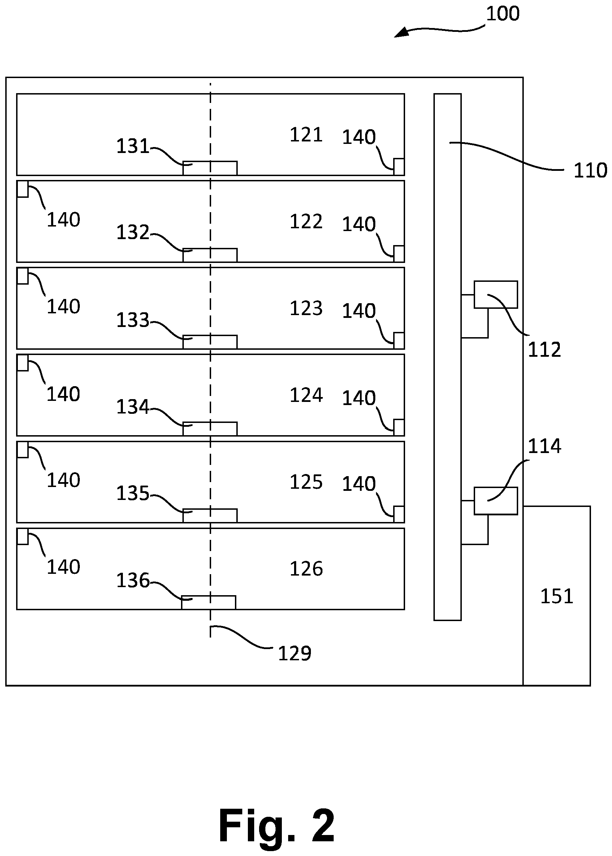

In Figure 1 an embodiment of a stocker according to the present invention is schematically depicted in a top view and collectively referred to with reference numeral 100. In Figure 2, the stocker 100 is shown in a side view.

Stocker 100 comprises a motorized storage unit, here configured as a storage carousel 120, which, in the example shown, comprises six axial storage portions 121, 122, 123, 124, 125, 126, each of which are configured to hold a predefined number of semiconductor fabrication articles, for example reticles, in a corresponding number of storage positions arranged around a circumference of the storage carousel 120. Each of the axial storage portions 121, 122, 123, 124, 125, 126 is rotatable about a common rotation axis 129 by a respective dedicated motor 131, 132, 133, 134, 135, 136. The motors may be arranged in a circumferential position in relation to the storage carousel or in a position on the rotation axis 129. During operation of the stocker, when an article, such as a reticle, is to be stored within one of the storage positions in the stocker 100, the respective article is received from a periphery of the stocker 100 via a load port 151, 152, 153, 154. Generally, any of the load ports 151, 152, 153, 154 may be used for loading an article into or out of the stocker 100. It is to be noted, however, that it is preferred to use a load port associated with a handling device 112, 114 that is not performing any handling operation at the time of request or that is further advanced with a previously requested handling operation.

In the example shown, two load ports 151, 152 are associated with a first handling device 112 and two further load ports 153, 154 are associated with a second handling device 114. In the example shown, each of the handling devices 112, 114 is movably arranged on a respective vertical rail 110, which may, for example, comprise a gear rack for controlled vertical positioning of the respective handling device 112, 114. This configuration is, however, purely exemplary and any other conceivable way of controlling the vertical position of the handling devices 112, 114 may be used. The handling devices 112, 114 are configured to access their respective load ports 151, 152, 153, 154 to place an article therein and/or to remove an article therefrom. Further the handling devices 112, 114 are configured to access storage positions within the storage carousel 120 to place (i.e. store) an article therein and/or to retrieve an article therefrom. In order to access a specific storage position, the respective handler 112, 114 moves along the vertical rail 110 to the respective vertical location, in which the storage position is situated, and the storage carousel 120 rotates in order to move the respective storage position to a circumferential location accessible by the handling device. Particularly, only the axial storage portion, in which the respective storage position is located, is rotated by its respective motor, so that all the remaining storage portions remain accessible for the other one of the two handling devices 112, 114.

When storing an article within a storage position, the location of the storage position may be registered, for example in a central monitoring system of the semiconductor fabrication facility (not shown in the drawings), in order to easily retrace the article, when it is needed again. Alternatively, every article may have a unique storage position associated therewith, such that an article is always stored within the same storage position and no other article is stored within that specific storage position. If, at a later point in time, this article needs to be retrieved, the stocker 100 may be controlled to retrieve the article. In such a case, the respective storage position is identified, for example by retrieving an information about the location of the desired article from the mentioned central monitoring system. Then the article is retrieved by one of the handling devices, for example by handling device 112 in the manner described above. The retrieved article is then transferred to one of the load ports 151, 152 associated with the handling device 112 and processed (e.g. encased into a transport container) for transfer to the periphery of stocker 100.

Storing of an article within the stocker 100 comprises essentially the same steps as retrieving the article from the stocker, only in essentially reverse order: The handling device 112, 114 accesses the respective load port 151, 152, 153 or 154, in which the article to be stored is contained (being unloaded from any transportation container by the respective load port) to transfer the article from the load port into the stocker 100. The relevant storage position is moved to a circumferential location of the storage carousel 120 accessible by one of the handling devices 112, 114, the respective handling device 112, 114 (carrying the article) is moved to the right axial (i.e. vertical) location, and accesses the storage position for storing the article therein. Finally, the handling device is retracted from the storage position. At this point in time, the handling device used is ready for the next handling operation, i.e. storing or retrieving of (another) article.

In the example shown, each of the axial storage portions 121, 122, 123, 124, 125, 126 is mechanically couplable with its respective neighbouring storage portion by a coupler 140. For example, axial storage portion 123 is mechanically couplable with axial storage portion 122 and/or storage portion 124, respectively. Therefore, for example in the event of a motor failure, each of the axial storage portions may be coupled with one of its neighbouring storage portions in order to be rotated by the respective motor of the neighbouring storage portion. In such a case, the respective failed motor may be decoupled from the respective storage portion and/or the rotational axis 129 in order to prevent interference with a rotation effected by the motor of the respective neighbouring storage portion. In some embodiments, this may not be necessary, for example when using motors that do not prevent free rotation in idle mode. The coupler 140 may, for example, be provided in the form of a movable bolt on one or both of the two neighbouring axial storage portions with a corresponding recess for accepting the bolt in case a coupling is desired. Other methods of coupling may also be used, for example, magnetic coupling using a (e.g. retractable or rotatable) permanent magnet or a switchable electromagnet with a respective (e.g. ferromagnetic) counterpart on the respective neighbouring storage portion. The coupler may be arranged in one or more circumferential positions and may couple the two neighbouring storage portions in predefined or arbitrary mutual rotatory positional relation.

In a case, in which more than one of the motors 131, 132, 133, 134, 135, 136 have failed, the corresponding storage portions may each be coupled to a neighbouring storage portion whose respective motor is still working or several mutually adjacent storage portions may be coupled together to the same storage portion with a working corresponding motor neighbouring at least one of the mutually adjacent storage portions. For example, if motors 135 and 136 are both not functional, both storage portions 125 and 126 may be coupled to each other and storage portion 125 may also be coupled to storage portion 124. In this case, motor 134 may rotate all three storage portions 124, 125 and 126 simultaneously. In another example, in which motors 134 and 135 are not functional, it may be more advantageous to couple storage portion 125 to storage portion 126 to be moved simultaneously by motor 136 and to couple storage portion 124 to storage portion 123 to be moved simultaneously by motor 133. This provides for larger parts of the storage carousel being moveable independently from one another. In at least one embodiment, it may be determined, which combination of storage portions leaves the maximum amount of occupied storage positions in an independently moveable state and to use the determined combination, in order to maximise throughput.

The foregoing description uses the example of a storage carousel 120 as the motorized storage unit. However, this configuration is not in all conceivable cases necessary for utilizing the present invention. Any other motorized storage unit can also be used instead of - or in addition to - the described storage carousel 120. One alternative example of a motorized storage unit configuration includes a (vertically or horizontally arranged) paternoster-type storage unit, but other motorized storage unit configurations are also useable in connection with this invention.

In some embodiments, at least two load ports (particularly those associated with the same handling device) may be vertically stacked one above the other.

The inner volume of the stocker 100 may be sealed against an atmosphere surrounding the stocker 100 and/or purged continuously or at intervals in order to minimize chemical and/or particulate contamination of the stored articles. Any conventionally used methods or devices to effect such sealing and/or purging functionality may be selected.

## Claims

1. Stocker (100) for storing a semiconductor fabrication article, particularly a reticle, with a motorized storage unit (120), particularly a rotatable storage carousel, with a plurality of storage positions and at least two handling devices (112, 114) each configured to access the storage positions and to place an article therein for storage or to retrieve an article therefrom, wherein the at least two handling devices (112, 114) are arranged at different positions with respect to the storage unit (120) and are configured to access storage positions within the storage unit (120) substantially independently of one another.

2. Stocker (100) for storing a semiconductor fabrication article, particularly a reticle, with a motorized storage unit (120), particularly a rotatable storage carousel, with a plurality of storage positions and at least one handling device (112, 114) configured to access the storage positions and to place an article therein for storage or to retrieve an article therefrom, particularly a stocker (100) according to claim 1, wherein the storage unit (120) comprises at least two, three, four, five or more storage portions (121, 122, 123, 124, 125, 126), wherein each one of the storage portions (121, 122, 123, 124, 125, 126) comprises a motor (131, 132, 133, 134, 135, 136) configured to displace the respective storage portion (121, 122, 123, 124, 125, 126) substantially independently of any of the remaining storage portions (121, 122, 123, 124, 125, 126).

3. Stocker (100) according to claim 2, wherein neighbouring storage portions (121, 122, 123, 124, 125, 126) are mechanically couplable (140) such that two or more coupled storage portions can be simultaneously displaced by means of the motor (131, 132, 133, 134, 135, 136) of one of the coupled storage portions (121, 122, 123, 124, 125, 126).

4. Stocker (100) according to claim 1, 2 or 3, comprising at least one load port (151, 152, 153, 154) accessible by the at least one or at least two handling devices (112, 114).

5. Stocker (100) according to any one of the preceding claims, wherein each of the at least two storage positions is configured to hold exactly one article, particularly without any encasement or carrier.

6. Method of operating a stocker (100) for storing a semiconductor fabrication article, the stocker comprising a motorized storage unit (120) with a plurality of storage positions and at least two handling devices (112, 114), the method comprising controlling a first one (112) of the at least two handling devices (112, 114) to perform a first handling operation regarding a first article, the first handling operation comprising accessing a first storage position of the plurality of storage positions within the storage unit (120) of the stocker (100) and controlling a second one (114) of the at least two handling devices (112, 114) to perform a second handling operation regarding a second article, the second handling operation comprising accessing a second storage position of the plurality of storage positions within the storage unit (120).

7. Method according to claim 6, wherein the second handling operation is performed during a time in which the first handling device (112) is performing at least a part of the first handling operation, wherein the second storage position is different from the first storage position.

8. Method according to claim 6 or 7, comprising controlling the motorized storage unit (120) to move the first storage position within a reach of the first handling device (112) and the second storage position within a reach of the second handling device (114), respectively.

9. Method of operating a stocker (100) for storing a semiconductor fabrication article, the stocker comprising a motorized storage unit (120) with a plurality of storage positions and at least one handling device (112, 114), particularly a method according to any one of claims 6 to 8, wherein the storage unit (120) comprises at least two, three, four, five or more storage portions (121, 122, 123, 124, 125, 126), wherein each one of the storage portions (121, 122, 123, 124, 125, 126) is displaceable independently of any of the remaining storage portions (121, 122, 123, 124, 125, 126) by a respective motor (131, 132, 133, 134, 135, 136), the method comprising
controlling the at least one handling device (112, 114) to perform a first handling operation regarding a first article, the first handling operation comprising accessing a first storage position of the plurality of storage positions within the storage unit (120) of the stocker (100) and controlling the at least one handling device (112, 114) to perform a second handling operation regarding a second article, the second handling operation comprising accessing a second storage position of the plurality of storage positions within the storage unit (120),
identifying the storage portions (121, 122, 123, 124, 125, 126) in which the first and second storage positions are located, respectively;
controlling the respective motor (131, 132, 133, 134, 135, 136) of the identified storage portions to move the first and second storage positions within the reach of the at least one handling device (112, 114), respectively;
determining if the displacement of the identified storage portions was effected as controlled, and, in case at least one storage portion was not displaced as controlled;
coupling the respective storage portion with a neighbouring storage portion and controlling the motor of the neighbouring storage portion to move the first or second storage position within the reach of the at least one handling device(112, 114).
